# FASCICULE DE BREVET EUROPEEN

(11) **EP 3 520 209 B1**
(45) Date de publication et mention de la délivrance du brevet: **25.11.2020**
(21) Numéro de dépôt: 17792110.3
(22) Date de dépôt: 02.10.2017
(51) Int. Cl.: H02K 21/48, H02K 16/02

(54) **TURBOPROPULSEUR D'AÉRONEF MUNI D'UNE MACHINE ÉLECTRIQUE**
MIT EINER ELEKTRISCHEN MASCHINE AUSGESTATTETES FLUGZEUGTURBOPROP
AIRCRAFT TURBOPROP EQUIPPED WITH AN ELECTRICAL MACHINE

(30) Priorité: 03.10.2016 FR 1659513
(43) Date de publication de la demande: 07.08.2019
(73) Titulaire: Safran Helicopter Engines, 64510 Bordes (FR)
(72) Inventeur: KLONOWSKI, Thomas, 77550 Moissy-Cramayel (FR); LAFARGUE, Olivier, 77550 Moissy-Cramayel (FR); MOUTAUX, Antoine, 77550 Moissy-Cramayel (FR); VONFELT, Jean-Julien, Camille, 77550 Moissy-Cramayel (FR); NOGAREDE, Bertrand, 11110 Coursan (FR)
(74) Mandataire: Brevalex
(86) Numéro de dépôt international: PCT/FR2017/052692
(87) Numéro de publication internationale: WO 2018/065709

(56) Documents cités:
- EP-A1- 0 642 209
- EP-A1- 2 688 184
- EP-A1- 3 007 336
- EP-A2- 1 096 648
- EP-A2- 2 404 775
- EP-A2- 2 456 056
- GB-A- 2 184 609
- GB-A- 2 264 812

## Description

Le sujet de l'invention est un turbopropulseur d'aéronef muni d'une machine électrique.

Les turbopropulseurs comprennent une hélice, un arbre porte-hélice et une turbine à gaz qui est généralement reliée à l'arbre porte-hélice pour entraîner cette dernière. Au cours d'un vol standard, l'aéronef reproduit cinq phases : roulage au sol avant décollage ou « taxiage », décollage, vol, atterrissage puis « taxiage » à nouveau. Pendant le vol, l'aéronef se déplace propulsé par l'hélice, elle-même entraînée en rotation par la turbine à gaz. Il existe toutefois d'autres modes d'entraînement de l'hélice, parmi lesquels celui qu'on réalise lorsque la turbine à gaz est inactive et notamment pendant le « taxiage ». Ce mode de déplacement à turbine coupée est apprécié parce qu'il implique une économie importante de carburant. On a alors recours à un moteur électrique pour mouvoir l'aéronef. L'aéronef nécessite aussi une fourniture constante d'électricité pour assurer diverses servitudes, parmi lesquelles on mentionnera le dégivrage de l'hélice, qui peut être accompli indépendamment du fonctionnement du moteur électrique. L'art antérieur comprend (GB 2 264 812 A et GB 584 563 A) des turbopropulseurs dotés de machines électriques disposées autour de l'arbre porte-hélice soit pour accomplir le dégivrage, soit pour fonctionner ou modifier le calage d'attaque des pales de l'hélice en générateurs d'électricité réversibles, aptes donc à entraîner l'arbre porte-hélice quand nécessaire. Une construction répandue (US 2 488 392 A) comporte deux machines électriques se succédant le long de l'arbre porte-hélice et qui peuvent donc assurer indépendamment ces deux fonctions, mais on observe que l'agencement est très compliqué et implique un accroissement de masse et d'encombrement important. Et les dispositifs de dégivrage connus, fondés sur l'emploi de collecteurs à balais pour transmettre un courant généralement continu à un dispositif tournant car incorporé à l'hélice et à l'arbre porte-hélice, sont eux-mêmes complexes, et sujets à une usure.

L'objet fondamental de l'invention est de fournir une machine électrique facilement intégrée à la structure d'un turbopropulseur et qui soit apte à accomplir plusieurs fonctions de fourniture d'énergie parmi lesquelles le dégivrage d'une hélice, avec un encombrement et une masse réduits.

L'invention concerne un turbopropulseur muni d'une machine électrique qui satisfait à cette exigence, et plus précisément un turbopropulseur, comprenant une hélice, un arbre porte-hélice et une machine électrique autour de l'arbre porte-hélice, caractérisé en ce que le machine électrique comprend une première machine formée sur un stator et un premier rotor, et une seconde machine formée sur le stator et un second rotor correspondant à l'arbre porte-hélice, le stator, le premier rotor et le second rotor étant concentriques, la première machine et la seconde machine étant commandées par des circuits électriques différents, la première machine étant réversible et la seconde machine électrique appartenant à un circuit de dégivrage de l'hélice, le second rotor portant un bobinage induit, et le premier rotor est relié au second rotor par une transmission mécanique.

On obtient alors deux machines électriques dont les fonctionnements sont indépendants, mais qui sont intégrées l'une à l'autre en une disposition compacte à la structure simple, et susceptible d'occuper un volume et une masse réduits dans un turbopropulseur et un aéronef: avec notamment un encombrement axial réduit et très peu d'équipements de liaison mécanique entre les éléments de la machine et les autres parties du turbopropulseur. Les connexions électriques n'ont pas non plus besoin d'être compliquées.

Une bonne intégration de la machine de l'invention dans son environnement de turbopropulseur est réalisée. Les deux machines fonctionnent indépendamment, et quel que soit l'état - tournant ou au repos - de l'arbre porte-hélice.

Un autre aspect de l'invention est un aéronef équipé d'un tel turbopropulseur.

Les différents aspects, caractéristiques et avantages de l'invention seront maintenant décrits au moyen des figures suivantes :
- la figure 1 illustre schématiquement un turbopropulseur équipé de l'invention ;
- la figure 2 illustre une réalisation de la machine électrique ;
- et la figure 3, une autre réalisation de la machine électrique.

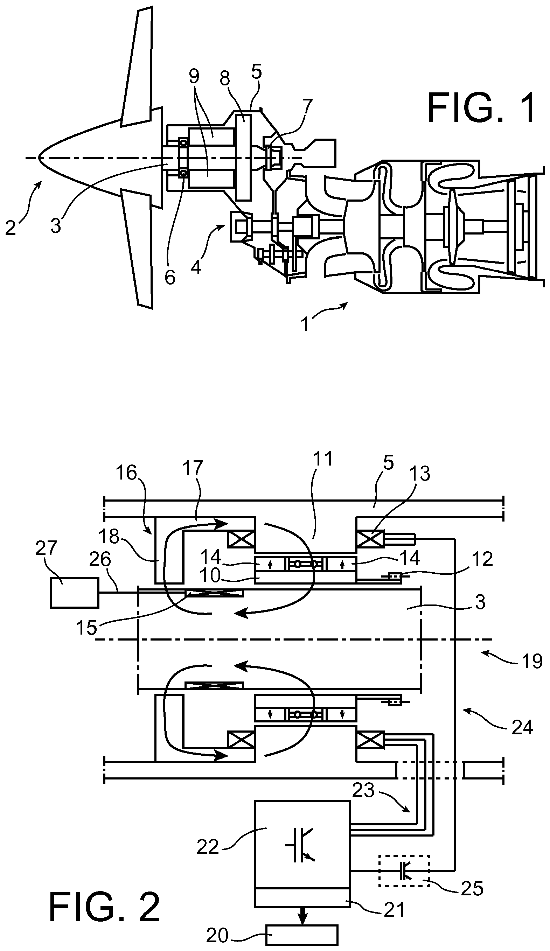

La figure 1 représente le turbopropulseur de l'invention, comprenant une turbine à gaz 1, une hélice 2, un arbre porte-hélice 3, s'étendant vers la turbine à gaz 1 et pouvant être connecté à un arbre de turbine 4, qui lui est parallèle et s'étend à peu de distance de lui, par une transmission connue et qui n'est pas représentée. L'arbre porte-hélice 3 est entouré par un carter 5 de protection. Il est soutenu dans le carter 5 par des roulements 6 et 7. L'un des roulements 6 est proche de l'hélice 2, et l'autre des roulements 7 est adjacent à une roue dentée 8 d'entraînement de l'arbre porte- hélice 3, qui engrène avec la transmission mentionnée ci-dessus. Une machine électrique 9, caractéristique de l'invention, est disposée autour de l'arbre porte-hélice 3, entre le premier roulement 6 et la roue dentée 8, en étant entourée par le carter 5 L'aéronef de l'invention n'est pas modifié par ailleurs et n'est donc pas représenté en entier.

On passe à la figure 2, qui décrit la machine électrique 9.

Dans ce mode de réalisation, l'arbre porte-hélice 3 est entouré par un rotor 10 concentrique, lui-même entouré par une couronne de stator 11 appartenant au carter 5. La couronne de stator 11 est munie d'un bobinage principal 13 qui peut être triphasé mais plus généralement multiphasé. Le rotor 10 est muni d'une couronne de pôles magnétiques 14. Enfin, l'arbre porte-hélice 3 est muni d'un bobinage récepteur 15 légèrement décalé axialement du rotor 10 et de la couronne de stator 11. D'autres équipements qu'on peut reconnaître sur cette figure 2 sont une denture 12 disposée à l'extrémité du rotor 10 intérieur et qu'on connecte à une transmission mécanique pour communiquer une énergie mécanique au rotor 10 ou au contraire recueillir cette énergie selon le mode de fonctionnement de la machine; un pont magnétique 16, comprenant une partie 17 reliée au stator 11 et d'extension axiale et cylindrique, et une partie 18 d'extension radiale et s'étendant depuis la précédente jusqu'à une extrémité proche de l'arbre porte-hélice 3, soit devant le bobinage récepteur 15, soit à côté, de sorte que le bobinage récepteur 15 s'étend alors entre cette partie 18 et le rotor 10 ; et un dispositif électrique 19 reliant le bobinage principal 13 à un bus continu 20 et comprenant notamment, à partir de ce dernier, des filtres 21, un convertisseur principal 22, un circuit principal 23 composé d'au moins trois fils menant aux phases du bobinage principal 13 et un circuit auxiliaire 24, muni d'un convertisseur auxiliaire 25, et menant au neutre du bobinage principal 13.

Voici comment le dispositif fonctionne. Le bobinage principal 13 et le rotor 10 pourvu de la couronne de pôles magnétiques 14 forment une première machine électrique apte, selon les exigences du moment, à fournir une énergie électrique à l'aéronef, ou au contraire une énergie mécanique permettant de le mouvoir, alors que la turbine à gaz 1 est à l'arrêt. La transmission par laquelle l'énergie mécanique du rotor 10 est exploitée peut consister en un train d'engrenages 40 planétaire reliant la denture 12 à une denture 41 de l'arbre porte-hélice 3, pour faire tourner celui-ci, par l'intermédiaire de satellites 42 dont l'axe est solidaire du stator (relié au carter 5). Des transmissions de ce genre permettent donc des transmissions de puissance réversibles entre le rotor 10 et l'arbre porte-hélice 3.

Le bobinage récepteur 15 est un bobinage induit qui, associé au bobinage principal 13, forme une seconde machine électrique, fonctionnant uniquement en génératrice et qui est prévue pour être affectée au dégivrage des pales de l'hélice 2 : un circuit électrique 26, solidaire de l'arbre porte-hélice 3, relie à cet effet le bobinage récepteur 15 à un dispositif chauffant 27 thermo-électrique contenu dans l'hélice 2 ; il peut être très simple et composé notamment de fils conducteurs. D'une façon générale, l'invention permet de ne pas recourir à des connecteurs électriques tournants à frottement, les bobinages liés au stator dépendent d'équipements de commande solidaires du stator, et le bobinage lié à l'arbre porte-hélice desservant un équipement disposé sur cet arbre, ou sur l'hélice qui lui est lié.

On s'aperçoit que la machine électrique combinée est facilement intégrée au turbopropulseur, en occupant en pratique une cavité du carter 5 qui était vide auparavant, et que son aménagement fait appel à un nombre réduit de pièces et nécessite peu de modifications de la structure existante, si bien que la masse et l'encombrement sont réduits. On évite en particulier la nécessité de transmettre l'électricité d'une génératrice fixe à l'arbre porte-hélice 2 par un collecteur à balais; le groupement d'une portion de chaque machine sur le stator 11 (et, ici, dans le même bobinage principal 13) est très économique ; et l'emploi d'une machine réversible est aussi très avantageux, tout en permettant de combiner le dégivrage au « taxiage » grâce à la seconde machine électrique.

Voici comment un fonctionnement indépendant des deux machines électriques est obtenu. La première machine électrique est de fonctionnement classique et son fonctionnement est fondé sur l'interaction électromagnétique entre le bobinage principal 13 et les pôles magnétiques 14 qui lui sont concentriques. L'énergie électrique passe par le circuit principal 23. La seconde machine électrique fonctionne par induction du bobinage récepteur 15 au moyen d'un flux magnétique homopolaire produit par le bobinage principal 13. Le flux homopolaire est en forme de boucle passant par le pont magnétique 16, l'arbre porte-hélice 3, le rotor 10 intérieur et le stator 11, et donc par le bobinage récepteur 15. Le bobinage récepteur 15, étant à l'écart du flux principal, est donc excité seulement quand cette composante homopolaire est imposée au bobinage principal 13, indépendamment du fonctionnement en moteur ou générateur de la première machine électrique. Le courant fourni au dispositif chauffant 27 peut être alternatif, ou rendu continu par un redresseur. Enfin, la vitesse de rotation (ou le repos) de l'arbre porte-hélice 3 n'a pas d'influence.

La composante de flux homopolaire peut être créée par un générateur de courant alternatif indépendant, connecté entre le pôle négatif de l'alimentation primaire du convertisseur principal 22 et le point neutre du bobinage principal 13, afin de superposer aux courants principaux une composante homopolaire à haute fréquence, en instaurant un déséquilibre des phases du bobinage principal 13 excitateur, par une modification de la tension du neutre par le circuit 24, avec un montage en étoile des phases du bobinage principal 13. On peut recourir au convertisseur auxiliaire 25 pour donner ce courant supplémentaire, ou au convertisseur principal 22 lui-même, en exploitant la fréquence de découpage à haute fréquence de celui-ci en faisant en sorte que les courants instantanés du bobinages 13 soient volontairement déséquilibrés, leur somme non nulle formant ainsi un courant homopolaire ; le convertisseur auxiliaire 25 serait alors omis.

La commande des deux machines électriques par deux circuits 23 et 24 électriques différents garantit l'indépendance de leurs fonctionnements. Par commodité, on dira que le circuit « commande » la machine réversible même si elle fonctionne en moteur.

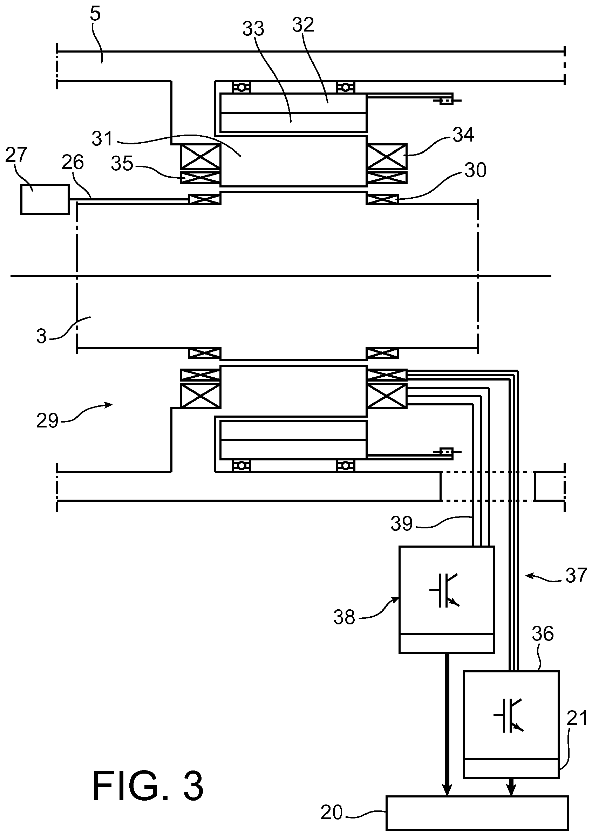

Un autre mode de réalisation de l'invention sera décrit au moyen de la figure 3. La machine électrique porte la référence 29. L'arbre porte-hélice 3 comprend de nouveau un bobinage récepteur 30, et il est entouré par une couronne de stator 31 et un rotor 32. Le rotor 32 est pourvu d'une couronne de pôles magnétiques 33, comme précédemment ; toutefois, il entoure ici la couronne de stator 31, qui s'étend donc entre lui et l'arbre porte-hélice 3. La couronne de stator 31 porte un bobinage principal 34 et un bobinage auxiliaire 35 concentrique, le bobinage principal 34 étant à l'extérieur. De plus, le bobinage récepteur 30 est concentrique au bobinage auxiliaire 35.

Le bobinage auxiliaire 35, triphasé, est commandé par un convertisseur auxiliaire 36 auquel il est relié par un circuit électrique 37 à trois fils. Le convertisseur auxiliaire 36 est par ailleurs relié au bus continu 20 par des filtres 21, comme c'était le cas du convertisseur principal 22 de la réalisation précédente. Et le bobinage principal 34 est commandé par un convertisseur 38 et un circuit électrique 39 analogues et indépendants.

La première machine électrique de ce dispositif est constituée par les pôles magnétiques 33 du rotor 32 et le bobinage principal 34; il s'agit d'une machine réversible dont le fonctionnement est le même que le précédent.

La seconde machine électrique est composée du bobinage auxiliaire 35 qui est inducteur, et du bobinage récepteur 30 dans lequel un courant est induit par le précédent. L'induction ne fait pas ici nécessairement appel à une composante homopolaire éveillant un flux magnétique de forme particulière, mais comme précédemment, le bobinage récepteur 30 est affecté au dégivrage de l'hélice 2 par un dispositif de chauffage.

Une transmission mécanique 43, dont la description générale serait identique à celle de la transmission mécanique 40 déjà rencontrée, relie ici aussi le rotor 32 au carter 5 et leur permet d'échanger de la puissance mécanique dans un sens ou l'autre, en exploitant ainsi la réversibilité de la première machine électrique.

Les avantages de ce mode de réalisation sont analogues au précédent en ce qui concerne la bonne intégration de la machine électrique combinée dans le carter 5, sa compacité, sa simplicité.

Selon certaines caractéristiques :
- le stator porte au moins un bobinage 13, 34, 35 de la machine ;
- le bobinage 13 sur le stator est relié à chacun des circuits électriques ;
- la seconde machine est disposée sur le second rotor (l'arbre porte-hélice 3) soit face à une extrémité du pont magnétique adjacente au second rotor soit entre ladite extrémité et une portion du second rotor qu'entoure le stator ;
- la seconde machine électrique est reliée à un dispositif chauffant thermo-électrique.

## Revendications

1. Turbopropulseur, comprenant une hélice (2), un arbre porte-hélice (3) et une machine électrique (9, 29) autour de l'arbre porte-hélice, la machine électrique comprenant une première machine formée sur un stator (11, 31) et un premier rotor (10, 32), et une seconde machine formée sur le stator et un second rotor (3) correspondant à l'arbre porte-hélice, le stator, le premier rotor et le second rotor étant concentriques, la première machine et la seconde machine étant commandées par des circuits électriques (23, 24, 37, 39) différents, la seconde machine électrique appartenant à un circuit de dégivrage de l'hélice, le second rotor (3) portant un bobinage (15, 30) induit, **caractérisé en ce que**
la première machine est réversible et
le premier rotor est relié au second rotor par une transmission mécanique.

2. Turbopropulseur selon la revendication 1, **caractérisé en ce que** le stator porte au moins un bobinage (13, 34, 35), le premier rotor porte des pôles magnétiques (14, 33).

3. Turbopropulseur selon la revendication 2, **caractérisé en ce que** le bobinage (13) sur le stator est unique et commun à la première et à la seconde machine, et relié à chacun des circuits électriques.

4. Turbopropulseur selon la revendication 3, **caractérisé en ce que** le bobinage est multiphasé, le circuit électrique (23) de la première machine est relié aux phases du bobinage (13) sur le stator, et le circuit électrique (24) de la seconde machine est relié à un neutre dudit bobinage (13).

5. Turbopropulseur selon l'une quelconque des revendications 1 à 4, **caractérisé en ce qu'**il comprend un pont magnétique (16) entre le stator (11) et le second rotor (3), le bobinage (15) induit de la seconde machine étant disposé sur le second rotor soit face à une extrémité du pont magnétique adjacente au second rotor, soit entre ladite extrémité et une portion du second rotor qu'entoure le stator.

6. Turbopropulseur selon l'une quelconque des revendications 1 ou 2, **caractérisé en ce que** le premier rotor (32) entoure le stator (31), et la première machine et la seconde machine comprennent des bobinages concentriques (34, 35) disposés sur le stator.

7. Turbopropulseur selon la revendication 6, **caractérisé en ce que** le bobinage (35) de la seconde machine disposé sur le stator est concentrique à un bobinage (30) induit de la seconde machine disposé sur le second rotor.

8. Turbopropulseur selon l'une quelconque des revendications 1 à 7, **caractérisé en ce que** la seconde machine électrique est reliée à un dispositif chauffant thermo-électrique (27).

9. Aéronef, **caractérisé en ce qu'**il comprend un turbopropulseur selon l'une quelconque des revendications précédentes.

## Patentansprüche

1. Turboprop mit einem Propeller (2), einer Propelleraufnahmewelle (3) sowie einer elektrischen Maschine (9, 29) um die Propelleraufnahmewelle herum, wobei die elektrische Maschine
eine erste, auf einem Stator (11, 31) ausgebildete Maschine und
einen ersten Rotor (10, 32) sowie eine zweite, auf dem Stator ausgebildete Maschine und einen zweiten Rotor (3) umfasst, der der Propelleraufnahmewelle entspricht, wobei der Stator, der erste Rotor und der zweite Rotor konzentrisch sind, wobei die erste Maschine und die zweite Maschine von verschiedenen elektrischen Schaltkreisen (23, 24, 37, 39) gesteuert werden, wobei die zweite elektrische Maschine zu einem Enteisungsschaltkreis des Propellers gehört, wobei der zweite Rotor (3) eine Induktionswicklung (15, 30) trägt, **dadurch gekennzeichnet, dass**
die erste Maschine umkehrbar ist und
der erste Rotor über ein mechanisches Getriebe mit dem zweiten Rotor verbunden ist.

2. Turboprop nach Anspruch 1, **dadurch gekennzeichnet, dass** der Stator mindestens eine Wicklung (13, 34, 35) trägt und der erste Rotor Magnetpole (14, 33) trägt.

3. Turboprop nach Anspruch 2, **dadurch gekennzeichnet, dass** die Wicklung (13) auf dem Stator einzeln und für die erste und die zweite Maschine gemeinsam sowie mit jedem der elektrischen Schaltkreise verbunden ist.

4. Turboprop nach Anspruch 3, **dadurch gekennzeichnet, dass** die Wicklung mehrphasig ist, der elektrische Schaltkreis (23) der ersten Maschine mit den Phasen der Wicklung (13) auf dem Stator verbunden ist und der elektrische Schaltkreis (24) der zweiten Maschine mit einem Neutralleiter der Wicklung (13) verbunden ist.

5. Turboprop nach einem der Ansprüche 1 bis 4, **dadurch gekennzeichnet, dass** er eine Magnetbrücke (16) zwischen dem Stator (11) und dem zweiten Rotor (3) aufweist, wobei die Induktionswicklung (15) der zweiten Maschine auf dem zweiten Rotor entweder gegenüber einem Ende der Magnetbrücke angrenzend an den zweiten Rotor oder zwischen diesem Ende und einem Bereich des zweiten Rotors angeordnet ist, der den Stator umgibt.

6. Turboprop nach einem der Ansprüche 1 oder 2, **dadurch gekennzeichnet, dass** der erste Rotor (32) den Stator (31) umgibt, und die erste Maschine und die zweite Maschine konzentrische Wicklungen (34, 35) aufweisen, welche auf dem Stator angeordnet sind.

7. Turboprop nach Anspruch 6, **dadurch gekennzeichnet, dass** die Wicklung (35) der zweiten, auf dem Stator angeordneten Maschine konzentrisch zu einer auf dem zweiten Rotor angeordneten Induktionswicklung (30) der zweiten Maschine ist.

8. Turboprop nach einem der Ansprüche 1 bis 7, **dadurch gekennzeichnet, dass** die zweite elektrische Maschine mit einer thermoelektrischen Heizvorrichtung (27) verbunden ist.

9. Luftfahrzeug, **dadurch gekennzeichnet, dass** es ein Turboprop nach einem der vorhergehenden Ansprüche umfasst.

## Claims

1. Turboprop engine, comprising a propeller (2), a propeller-carrying shaft (3) and an electric machine (9, 29) around the propeller-carrying shaft, the electric machine comprising a first machine formed on a stator (11, 31) and a first rotor (10, 32), and a second machine formed on the stator and a second rotor (3) corresponding to the propeller-carrying shaft, the stator, the first rotor and the second rotor being concentric, the first machine and the second machine being controlled by different electric circuits (23, 24, 37, 39), the second electric machine belonging to a circuit for de-icing of the propeller, the second rotor (3) carrying an induced winding (15, 30), **characterised in that** the first machine is reversible and the first rotor is connected to the second rotor by a mechanical transmission.

2. Turboprop engine according to claim 1, **characterised in that** the stator carries at least one winding (13, 34, 35), the first rotor carries magnetic poles (14, 33).

3. Turboprop engine according to claim 2, **characterised in that** the winding (13) on the stator is the only one and shared by the first and the second machine, and connected to each of the electric circuits.

4. Turboprop engine according to claim 3, **characterised in that** the winding is multi-phase, the electric circuit (23) of the first machine is connected to the phases of the winding (13) on the stator, and the electric circuit (24) of the second machine is connected to a neutral of said winding (13).

5. Turboprop engine according to any one of claims 1 to 4, **characterised in that** it comprises a magnetic pole (16) between the stator (11) and the second rotor (3), the induced winding (15) of the second machine being disposed on the second rotor either facing an end of the magnetic pole adjacent to the second rotor, or between said end and a portion of the second rotor that is surrounded by the stator.

6. Turboprop engine according to any one of claims 1 or 2, **characterised in that** the first rotor (32) surrounds the stator (31), and the first machine and the second machine comprise concentric windings (34, 35) disposed on the stator.

7. Turboprop engine according to claim 6, **characterised in that** the winding (35) of the second machine disposed on the stator is concentric to an induced winding (30) of the second machine disposed on the second rotor.

8. Turboprop engine according to any one of claims 1 to 7, **characterised in that** the second electric machine is connected to a thermoelectric heating device (27).

9. Aircraft, **characterised in that** it comprises a turboprop engine according to any one of the previous claims.
